# EUROPÄISCHE PATENTSCHRIFT

(11) **EP 1 552 616 B1**
(45) Veröffentlichungstag und Bekanntmachung des Hinweises auf die Patenterteilung: **20.12.2006**
(21) Anmeldenummer: 03770910.2
(22) Anmeldetag: 14.10.2003
(51) Int. Cl.: H03M 1/46

(54) **VERFAHREN UND VORRICHTUNG ZUR WANDLUNG EINES ANALOGEN SIGNALS IN EIN DIGITALES SIGNAL**
METHOD AND DEVICE FOR CONVERSION OF AN ANALOGUE SIGNAL INTO A DIGITAL SIGNAL
PROCEDE ET DISPOSITIF POUR CONVERTIR UN SIGNAL ANALOGIQUE EN UN SIGNAL NUMERIQUE

(30) Priorität: 15.10.2002 DE 10248049
(43) Veröffentlichungstag der Anmeldung: 13.07.2005
(73) Patentinhaber: SIEMENS AKTIENGESELLSCHAFT, 80333 München (DE)
(72) Erfinder: HEMMERLEIN, Martin, 96052 Bamberg (DE); LANG, Georg, 92237 Sulzbach Rosenberg (DE); MÖSSNER, Rudolf, 93133 Burglengenfeld (DE); ZENGER, Hermann, 92533 Wernberg-Köblitz (DE)
(86) Internationale Anmeldenummer: PCT/DE2003/003405
(87) Internationale Veröffentlichungsnummer: WO 2004/036757

(56) Entgegenhaltungen:
- US-A- 5 296 856
- US-A- 6 075 478
- US-A- 6 094 154
- MAYES M K ET AL INSTITUTE OF ELECTRICAL AND ELECTRONICS ENGINEERS: "A MULTISTEP A/D CONVERTER WITH LIMITED RANGE SPANNING" PROCEEDINGS OF THE ASILOMAR CONFERENCE ON SIGNALS, SYSTEMS AND COMPUTERS. PACIFIC GROVE, OCT. 30 - NOV. 1, 1989, NEW YORK, IEEE, US, Bd. VOL. 2 CONF. 23, 30. Oktober 1989 (1989-10-30), Seiten 975-979, XP000217538

## Beschreibung

Verfahren und Vorrichtung zur Wandlung eines analogen Signals in ein digitales Signal

Die Erfindung betrifft ein Verfahren und eine Vorrichtung zur Wandlung eines analogen Signals in ein digitales Signal mit einer vorgegebenen festen Bitauflösung für einen vorgegebenen Messbereich.

Zur Umsetzung eines analogen elektrischen Signals in ein digitales Signal sind verschiedene Verfahren, wie z. B. das so genannte Parallelverfahren, das so genannte Wägeverfahren oder das so genannte Zählverfahren, bekannt. Beim so genannten Parallelverfahren wird eine Eingangsspannung gleichzeitig mit n-Referenzspannungen verglichen und dahingehend untersucht, zwischen welchen dieser Referenzspannungen die Eingangsspannung liegt. Ein derartiger Analog-Digital-Wandler (kurz AD-Converter oder ADC genannt) ist besonders aufwendig und benötigt für jede mögliche Zahl einen zugehörigen Komparator. Z. B. für einen Messbereich von 0 bis 100 in Schritten von 1 werden n = 100 Komparatoren benötigt.

Bei dem so genannten Wägeverfahren wird anstelle der Ermittlung des digitalen Signals in einem einzelnen Schritt oder in einer einzelnen Stufe nur jeweils eine Stelle der zugehörigen Dual- oder Binärzahl ermittelt. Je nach Bitauflösung oder Bitstelle wird beginnend mit der höchsten Stelle analysiert, ob die Eingangsspannung größer oder kleiner als eine vorgegebene Referenzspannung für die höchste Stelle ist. Zur Ermittlung des höchstwertigen Bits (im Weiteren MSB genannt, MSB = Most Significant Bit) wird die Referenz- oder Vergleichsspannung als Mittelwert des gesamten Messbereichs der Eingangsspannung vorgegeben. Anschließend werden alle weiteren Bitstellen nacheinander gewandelt, bis das niederwertigste Bit (im Weiteren LSB genannt, LSB = Least Significant Bit) ermitt-elt ist. Nachteilig dabei ist, dass so viele Vergleichsschritte oder -stufen erforderlich sind, wie die Dualzahl Stellen besitzt, und ebenso viele Referenzspannungen (= Vergleichswerte) erforderlich sind. Somit ist ein derartiges nach dem klassischen Wägeverfahren arbeitendes Analog-Digital-Verfahren besonders zeitaufwendig und erfordert darüber hinaus eine Vielzahl von Analogbausteinen zur Bereitstellung der Referenzspannung.

Bei dem so genannten Zählverfahren wird die Referenzspannung für die niedrigste Bitstelle so oft addiert, bis die Eingangsspannung erreicht ist. Die Zahl der Schritte ist somit gleich dem Ergebnis. Ein derartiges Verfahren ist zwar besonders einfach, hat aber den Nachteil, dass dieses besonders langsam und somit zeitaufwendig ist. Zusammenfassend sind die handelsüblichen Analog-Digital-Wandler mit hoher Auflösung schaltungstechnisch besonders komplex, aufwendig und kostenintensiv oder somit sehr zeitintensiv.

US 6075478 offenbart einen A-D Wandler mit schrittweiser Annäherung, der eine Umsetzung anhand eines Toleranzbereiches umfaßt. Wenn das Eingangssignlas außerhalb des Toleranzberreiches liegt, wird die Wandlung verschoben und nur wieder angefangen wenn das Eingangssignal zurück innerhalb des Toleranzbereiches ist. Obwohl US 6075478 eine A-D Wandlung anhand eines Toleranzbereiches offenbart, ist der Toleranzbereiches nicht dynamish bestimmt und sind alle Stufen in das Schrittweiser Approximationsregister benutzen.

Der Erfindung liegt daher die Aufgabe zugrunde, ein Verfahren zur Wandlung eines analogen Signals in ein digitales Signal mit einer vorgegebenen, festen Bitauflösung für einen vorgegebenen Messbereich anzugeben, bei welchem auch bei einer hohen Bitauflösung eine einfache und schnelle Analog-Digital-Umsetzung erfolgt. Darüber hinaus ist eine besonders einfache Vorrichtung zur Wandlung eines analogen Signals in ein digitales Signal anzugeben.

Die erstgenannte Aufgabe wird erfindungsgemäß gelöst bei einem Verfahren zur Wandlung eines analogen Signals in ein digitales Signal einer Signalfolge mit einer vorgegebenen, festen Bitauflösung für einen vorgegebenen Messbereich, bei dem ein aktuell erfasstes analoges Signal derart stufenweise approximiert wird, dass eine den Messbereich repräsentierende Anzahl von Approximationsstufen zur Wandlung des aktuell erfassten analogen Signals anhand eines Toleranzbereiches begrenzt wird, wobei der Toleranzbereich anhand eines dem aktuell erfassten analogen Signal vorangegangenen Signals bestimmt wird.

Die Erfindung geht dabei von der Überlegung aus, dass bei gegebener und somit fester Bitauflösung (kurz Auflösung genannt) die Digitalisierungszeit, d. h. die Anzahl der erforderlichen Wandlungsschritte, von der Größe des zu wandelnden analogen Signals und einem diesem Signal zugrunde liegenden Messbereich abhängt. Daher sollte zur Zeitersparnis das zu wandelnde analoge Signal und/oder der Messbereich klein gehalten werden. Dazu wird auf den Vorwert, d. h. auf das vorangegangene analoge Signal, zurückgegriffen und dieses Signal dahingehend analysiert, dass anstelle des gesamten Messbereiches ein die Änderung des aktuellen vom vorangegangenen analogen Signal repräsentierender Toleranzbereich vorgegeben wird. Dieser Toleranzbereich ist somit kleiner als der Messbereich. Mit anderen Worten: Durch Variation einer tolerierbaren Änderung oder Abweichung des aktuell erfassten von einem vorangegangenen Messwert wird die Anzahl der Wandlungs- oder Approximationsschritte begrenzt.

Zweckmäßigerweise wird für ein innerhalb des Toleranzbereiches liegendes analoges Signal das digitale Signal bestimmt. Bevorzugt wird für ein außerhalb des Toleranzbereichs liegendes analoges Signal der vorangegangene digitale Wert beibehalten oder ein den Toleranzbereich repräsentierender Grenzwert bestimmt und angenommen. Insbesondere beim Start des Verfahrens zur Wandlung des analogen Signals in ein digitales Signal wird vorzugsweise die Größe des Toleranzbereiches von einer Approximationsstufe bis zur maximalen Anzahl von Approximationsstufen vorgegeben. Mit anderen Worten: Die Größe des Toleranzbereiches ist parametrierbar. Dabei kann die Größe des Toleranzbereiches fest vorgegeben oder dynamisch angepasst werden. Zweckmäßigerweise wird dabei der Toleranzbereich anhand der Änderung von vorangegangenen analogen Signalen von mindestens zwei aufeinander folgenden Abtastungen bestimmt und/oder angepasst. Hierdurch können die Grenzen des Toleranzbereiches beliebig verschoben werden, was im Grenzfall zu keiner Wandlung eines analogen Signals in ein digitales Signal führen würde. Für eine hinreichend schnelle und möglichst hoch auflösende Analog-Digital-Umsetzung ist es jedoch erforderlich, dass eine zulässige Anpassung oder Veränderung des Toleranzbereiches zu gewährleisten ist, indem mindestens eine der Grenzen des Toleranzbereiches auf Plausibilität geprüft wird.

Bestimmend für eine optimale Änderung des Toleranzbereiches ist zweckmäßigerweise die durchschnittliche Änderung des aktuell erfassten analogen Signals vom vorangegangenen Messwert zwischen zwei oder mehreren aufeinander folgenden Abtastungen. D. h., Anfang und Ende und somit die Größe des Toleranzbereiches ist nicht an binäre Stufen und somit an die Anzahl der Approximationsstufen gekoppelt. Für eine Anpassung des Toleranzbereiches an eine Verschiebung des dem analogen Signal zugrunde liegenden Messwertes wird die Lage des Toleranzbereiches, insbesondere im zugrunde liegenden Messbereich, anhand des vorangegangenen analogen Signals derart bestimmt, dass das analoge Signal die Mitte des ToLeranzbereiches bildet. D. h., die Lage des Toleranzbereiches (auch Fenster genannt), insbesondere die Fenstermitte, richtet sich nach dem Wert des letzten, zu wandelnden analogen Signals. Die Größe des Fensters kann ebenfalls vom vorangegangenen Wert des analogen Signals abhängig sein, die Größe kann aber auch fest sein. Beispielsweise ist ein Messbereich von 0 bis 100 und für einen aktuellen Zyklus ein Toleranzbereich von 9 bis 25 anhand eines vorangegangenen Messwertes von 12 vorgegeben. Für den Fall, dass der aktuelle Messwert 13 beträgt, so ändert sich die Lage des Fensters auf einen Toleranzbereich für die nächste Wandlung von 10 bis 26. In diesem Fall ist die Größe des Toleranzbereiches fest, sie kann aber auch anhand der vorangegangenen Messwerte adaptiv angepasst werden.

Bezüglich der Vorrichtung wird die gestellte Aufgabe erfindungsgemäß dadurch gelöst, dass ein Steuerungsmodul zur BeStimmung und Einstellung eines Toleranzbereiches vorgesehen ist, anhand dessen ein Steuersignal zur Steuerung eines sukzessiven Approximationsregisters derart generierbar ist, dass die zur Digitalisierung des analogen Signals zu durchlaufenden Approximationsstufen des Approximationsregisters begrenzbar sind. Mit anderen Worten: Zur Reduzierung der Stufenanzahl der Analog-Digital-Umsetzung ist das Approximationsregister zweckmäßigerweise zur Bestimmung des digitalen Signals für ein innerhalb des Toleranzbereiches liegendes aktuelles analoges Signal ausgebildet. Dabei wird nur für innerhalb des Toleranzbereiches liegende Approximationsstufen ein Vergleichswert bestimmt und mit dem aktuellen analogen Signal verglichen.

Zur Vorgabe des Toleranzbereiches von einer Approximationsstufe bis zur maximalen Anzahl von Approximationsstufen ist zweckmäßigerweise ein Eingabemodul vorgesehen. Hierdurch wird das Approximationsregister insbesondere beim Start des Analog-Digital-Umsetzungsverfahrens derart initialisiert, dass beispielsweise bei einer Eingangsspannung mit einem Messbereich von 0 bis 100 Volt und einer diese physikalische Größe repräsentierenden maximalen Änderung von +/-10 Volt zwischen zwei aufeinander folgenden Abtastungen und bei einem üblichen Messwert von 25 Volt für den Toleranzbereich als Grenzwerte Gmin = 15 und Gmax = 35 vorgegeben werden. Für eine dynamische Anpassung des Toleranzbereiches anhand der Änderung des analogen Signals ist zweckmäßigerweise ein Differenzmodul zur Bestimmung der Änderung des aktuellen analogen Signals vom vorangegangenen analogen Signal vorgesehen. Dabei wird die Änderung anhand der letzten Änderung oder des mittleren Wertes von mehreren letzten Änderungen ermittelt. Je nach Art und Ausbildung kann das Differenzmodul im Approximationsregister und/oder Steuerungsmodul integriert sein.

Zweckmäßigerweise ist ein Digital-Analog-Wandler zur Bestimmung und Zuführung eines die jeweilige Approximationsstufe repräsentierenden Vergleichswertes an den Komparator vorgesehen. Hierbei wird der vom Approximationsregister ermittelte digitale Wert (= Digitalwert) in einen analogen Vergleichswert umgewandelt und zum Vergleich mit dem aktuell erfassten analogen Wert dem Komparator zugeführt. Bevorzugt erzeugt der Digital-Analog-Wandler aus dem vorangegangenen digitalen Signal einen als Puls-Pausen-Signal gebildeten Vergleichswert.

Zur Anpassung des Toleranzbereiches anhand der Änderung des analogen Signals von zwei oder mehreren aufeinander folgenden Abtastungen ist das Steuerungsmodul und/oder das Approximationsregister entsprechend ausgebildet. Für eine besonders einfache Ausführung der Vorrichtung zur Wandlung des analogen Signals in ein digitales Signal ist zweckmäßigerweise das Approximationsregister als integrierte Schaltung ausgeführt. Der zur Vorgabe des digitalen Signals vorgesehene Digital-Analog-Wandler ist zweckmäßigerweise als integrierte Schaltung ausgebildet. Hierdurch ist sichergestellt, dass aufwendige analoge Schaltungen sicher vermieden sind. Insbesondere können die Komponenten - Approximationsregister und Digital-Analog-Wandler - der Vorrichtung in einen gemeinsamen digitalen Schaltkreis implementiert sein. Als analoge Schaltung umfasst die Vorrichtung dann lediglich eine einfache als Operationsverstärkerschaltung ausgebildete Komparatorschaltung. Alternativ kann die analoge und die digitale Schaltung in einem integrierten Schaltkreis realisiert werden.

Die mit der Erfindung erzielten Vorteile bestehen insbesondere darin, dass bei einem derartigen dynamischen Wägeverfahren nur diejenigen Approximationsstufen neu bestimmt und somit durchlaufen werden müssen, die innerhalb eines festen Toleranzbereiches liegen oder um die sich der Eingangswert seit der letzten Messung maximal geändert haben kann. Hierdurch ist eine deutliche Verkürzung der Wandlungszeit ermöglicht. Darüber hinaus ist durch die Begrenzung der Dynamik mittels eines zugehörigen Toleranzbereiches für die Anzahl der zu durchlaufenden Approximationsstufen ein äußerst robustes und gegenüber sporadisch auftretenden Störimpulsen sicheres Analog-Digital-Verfahren ermöglicht. Liegt beispielsweise zum Zeitpunkt der Abtastung eine starke Störung vor, so kann der Messwert maximal bis zur Grenze des eingestellten Toleranzbereiches verfälscht werden. Somit ist durch ein derartig dynamisch veränderbares Toleranzfenster oder durch einen derartigen Toleranzbereich eine Glättung eines fehlerhaften Eingangssignals ohne zusätzliche Filterschaltungen ermöglicht. Demgegenüber würden bei einem klassischen Wägeverfahren alle Stellen des Messwertes beeinflusst werden. Eine Kombination der Analog-Digital-Wandlung mit einer nach dem Pulsdichte-Verfahren arbeitenden Digital-Analog-Wandlung, welches an sich ein relativ langsames Digital-Analog-Wandlungsverfahren darstellt, ermöglicht eine sehr einfache Analogbeschaltung bei einer guten Wandlungsperformance. Aufwendige zusätzliche analoge Schaltungen sind sicher vermieden, da bedingt durch das Konzept der vorliegenden Anmeldung möglichst viel Analogtechnik durch Digitaltechnik ersetzt werden kann.

Ausführungsbeispiele der Erfindung werden anhand einer Zeichnung näher erläutert. Darin zeigen:
- Figur 1: eine Vorrichtung zur Wandlung eines analogen Signals in ein digitales Signal,
- Figur 2: schematisch ein Flussdiagramm für den Ablauf eines Verfahrens zur Wandlung des analogen Signals in das digitale Signal und
- Figur 3: schematisch die Vorrichtung nach Figur 1 mit einem Digital-Analog-Wandler zur Zuführung eines Vergleichswertes.

Einander entsprechende Teile sind in allen Figuren mit den gleichen Bezugszeichen versehen.

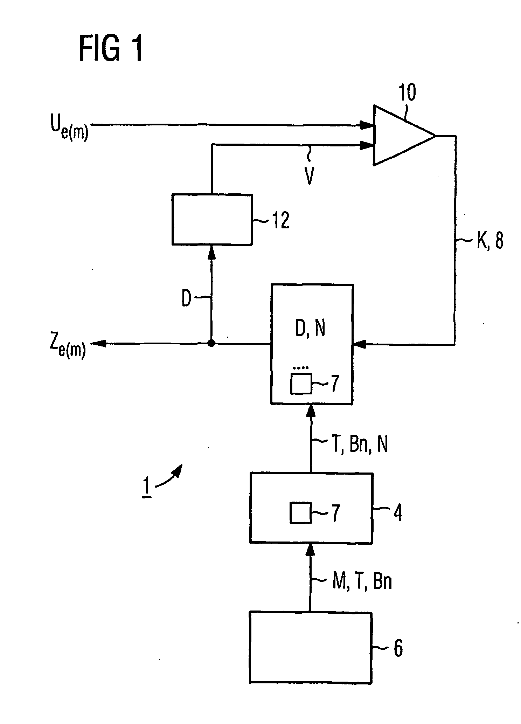

Figur 1 zeigt eine Vorrichtung 1 zur Wandlung eines analogen Signals Ue(m) in ein digitales Signal Ze(m) einer Signalfolge mit einer vorgegebenen festen, insbesondere maximalen Bitauflösung Bn für einen dem analogen Signal Ue(m) zugrunde liegenden Messbereich M.

Die Vorrichtung 1 wird im Weiteren als Analog-Digital-Wandler (kurz A/D-Wandler 1) bezeichnet. Das digitale Signal Ze(m) mit der wählbaren maximalen Bitauflösung Bn beschreibt dabei ein n-Bit breites Binärwort. Mit anderen Worten: Das digitale Signal Ze(m) wird für einen Binärwert im Zweierkomplement gemäß Ze = 0100 (hexadezimal), der dem Wert +4 dezimal entspricht, angegeben. Zur besseren Übersichtlichkeit wird häufig anstelle der Binärzahlen das digitale Signal Ze(m) in Dezimalzahlen zur Basis 16 (so genanntes Modulo 16) angegeben. Das analoge Signal Ue(m) stellt beispielsweise eine zu wandelnde Eingangsspannung dar. Dieses analoge Signal Ue(m) für die physikalische Größe "Eingangsspannung" weist beispielsweise einen vorgegebenen Messbereich M von 0 bis 100 Volt auf.

Zur Umsetzung des am Eingang des A/D-Wandlers 1 anliegenden analogen Signals Ue(m) in das digitale Signal Ze(m) umfasst der A/D-Wandler 1 ein Approximationsregister 2. Das Approximationsregister 2 ist dabei als sukzessives Approximationsregister ausgebildet. Der Aufbau und die Funktion eines sukzessiven Approximationsregisters ist beispielsweise aus dem europäischen Patent EP 0 258 840 B1 bekannt.

Das Approximationsregister 2 wird mittels eines Steuerungssignals S eines Steuerungsmoduls 4 derart gesteuert, dass die vom Approximationsregister 2 zu durchlaufenden Approximationsstufen N begrenzt sind. Die Anzahl der zur Digitalisierung eines aktuell erfassten analogen Signals Ue(m) zu durchlaufenden Approximationsstufen N wird dabei anhand eines vorgegebenen Toleranzbereiches T begrenzt.

Der Toleranzbereich T wird beispielsweise anhand eines dem aktuellen analogen Signal Ue(m) vorangegangenen analogen Signals Ue(m-1) bestimmt. Alternativ kann beim Start des Verfahrens der Toleranzbereich T in Abhängigkeit vom Messbereich M von einer Approximationsstufe N₁ bis zur maximalen Anzahl von Approximationsstufen Nₘₐₓ vorgegeben werden. Eine andere Alternative für die Vorgabe des Toleranzbereiches T besteht in dessen dynamischen Anpassung an die Änderung von vorangegangenen analogen Signalen (Ue(m-1) - Ue(m-2)) von mindestens zwei aufeinander folgenden Abtastungen.

Zur Vorgabe des Messbereiches M für das analoge Signal Ue(m) sowie für eine feste Vorgabe des die Approximationsstufen N des Approximationsregisters 2 begrenzenden Toleranzbereichs T ist ein Eingabemodul 6 vorgesehen. Beispielsweise wird für das analoge Signal Ue(m) ein Wertebereich oder Messbereich M von 0 Volt bis 100 Volt mittels des Eingabemoduls 6 vorgegeben. In Abhängigkeit von der dem analogen Signal Ue(m) zugrunde liegenden verfahrenstechnischen Größe, wie z. B. Eingangsspannung eines Messgebers eines Steuergerätes, kann der Messbereich M variieren. Bei einer Überwachung des analogen Signals Ue(m) und somit bei einer fortlaufenden Erfassung des analogen Wertes Ue(m) ändert sich dieser üblicherweise innerhalb einer tolerierbaren Abweichung vom vorangegangenen Messwert oder letzten analogen Signal Ue(m-1). Diese tolerierbare Änderung oder Abweichung wird auch bevorzugt zur Bestimmung des Toleranzbereiches T herangezogen und mittels des Steuerungsmoduls 4 und/oder des Approximationsregisters 2 bestimmt. Dazu weist das Steuerungsmodul 4 und/oder das Approximationsregister 2 ein Differenzmodul 7 auf, anhand dessen die aktuelle Änderung der letzten zwei Abtastungen oder der Mittelwert der letzten Änderungen mehrerer Abtastungen ermittelt und zur Bestimmung des Toleranzbereiches T berücksichtigt wird.

Im Betrieb des A/D-Wandlers 1 umfasst dieser zur stufenweisen Approximation des analogen Signals Ue(m) das getaktete Approximationsregister 2, dem über eine Leitung 8 ein Komparatorsignal K eines Komparators 10 zugeführt wird. Je nach Art und Ausführung kann der Komparator 10 mehrere hintereinander geschaltete Komparatorstufen umfassen. Mittels des Komparators 10 wird das aktuell erfasste analoge Signal Ue(m) mit einem Vergleichswert V verglichen. Der Vergleichswert V wird anhand eines die jeweilige Approximationsstufe N repräsentierenden digitalen Werts D gebildet, indem dieser in einem Digital-Analog-Wandler 12 in eine Analogspannung als Vergleichswert V gewandelt wird. Der so ermittelte Vergleichswert V für die jeweilige Approximationsstufe N wird dem Komparator 10 zum Vergleich mit dem aktuellen analogen Signal Ue(m) zugeführt, anhand des Komparatorsignals K wird dann die nächste Approximationsstufe N des Approximationsregisters 2 durchlaufen. Zur Begrenzung der Anzahl der zu durchlaufenden Approximationsstufen N und somit zu einer Beschleunigung der Analog-Digital-Wandlung des analogen Signals Ue(m) wird die Anzahl der Wandlungs- oder Approximationsstufen N anhand des Steuerungssignals S des Steuerungsmoduls 4 mittels des vorgegebenen Toleranzbereiches T begrenzt.

Zur Dynamisierung des dem Approximationsregister 2 zugrunde liegenden Wägeverfahrens wird daher mittels des Approximationsregisters 2 lediglich für diejenigen Approximationsstufen N der Digitalwert D neu bestimmt, dessen Vergleichswert V innerhalb des Toleranzbereiches T liegt. Dabei wird der Toleranzbereich T einerseits in Abhängigkeit vom vorangegangenen analogen Signal Ue(m-1) bestimmt. Andererseits kann der Toleranzbereich T, insbesondere dessen Größe, anhand der Änderung von mindestens zwei vorangegangenen analogen Signalen Ue(m-1) - Ue(m-2) bestimmt und/oder geändert werden. Durch ein derartiges dynamisches Wägeverfahren, welches hinsichtlich der zu durchlaufenden Approximationsstufen N derart reduziert wird, dass lediglich die den Toleranzbereich T repräsentierenden Approximationsstufen N durchlaufen werden und für diese der Digitalwert D neu bestimmt wird, ist eine deutliche Verkürzung der Wandlungszeiten des A/D-Wandlers 1 ermöglicht.

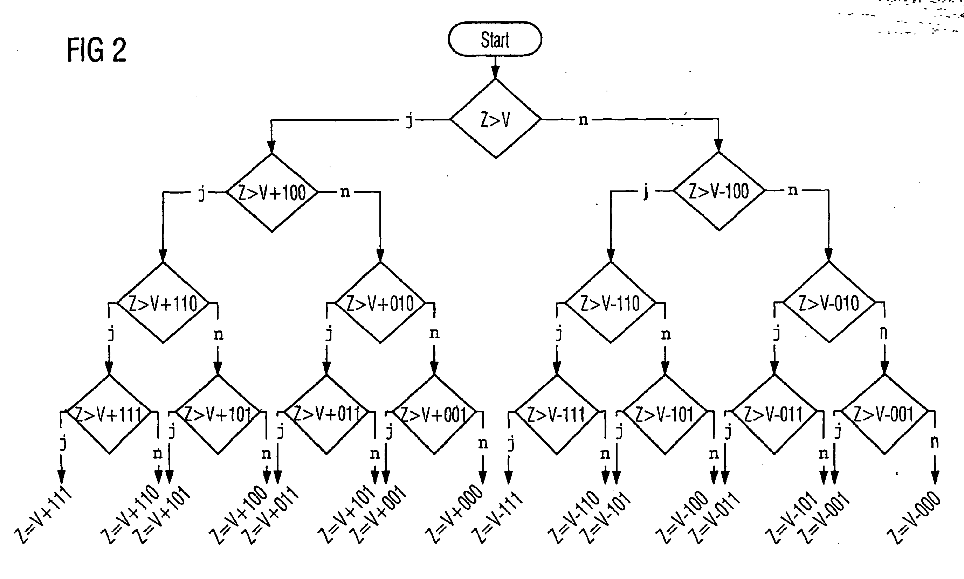

Figur 2 zeigt schematisch ein Flussdiagramm für den Ablauf eines derartigen dynamischen Wägeverfahrens mittels des A/D-Wandlers 1. Dabei ist in Figur 2 beispielhaft das dynamische Wägeverfahren mit einem Toleranzbereich T von drei Approximationsstufen N₃ mit einer entsprechenden Anzahl von Wandlungsschritten für eine Analog-Digital-Wandlung eines aktuell erfassten analogen Signals Ue(m) beschrieben, welches als Größe Z im Approximationsregister 2 verarbeitet wird.

Der Toleranzbereich T ist durch einen Dynamikbereich von +/-3 Bit gebildet. Dies entspricht beispielsweise bei einem analogen Signal Ue mit einem Messbereich M von 0 bis 100 einem Toleranzbereich T von -111 bis +111 (hexadezimal) bzw. einem Toleranzbereich T von -7 bis +7 (dezimal), welcher in der jeweiligen Approximationsstufe N₁ bis N₃ in herkömmlicher Weise zur Bildung des Vergleichswertes V addiert oder subtrahiert wird. Beim dynamischen Wägeverfahren mit dem in Figur 1 dargestellten A/D-Wandler 1 wird dabei in üblicher Art und Weise das analoge Eingangssignal Ue(m) als Z zugeführt. Gegenüber dem herkömmlichen Verfahren wird als Vergleichswert V das Wandlungsergebnis der letzten Wandlung, d. h. das vorangegangene analoge Signal Ue(m-1), bestimmt. Unter Berücksichtigung des Toleranzbereiches T, welcher kleiner ist als der Messbereich M, werden beim dynamischen Wägeverfahren nur diejenigen Stellen des Digitalwerts D und somit die Größe des Vergleichswertes bestimmt, um die sich der Eingangswert (= aktuelles analoges Signal Ue(m)) seit der letzten Messung geändert hat oder maximal ändern kann (= Signaldynamik). Dabei wird die maximale Änderung des analogen Signals Ue(m)- Ue(m-1) begrenzt durch die Grenzwerte G des Toleranzbereiches T.

Als Startgröße zur Begrenzung der Wandlungsschritte anhand des Toleranzbereiches T wird daher bevorzugt die Differenz oder die Änderung von zwei vorangegangenen analogen Messwerten Ue(m-1) - Ue(m-2) im Approximationsregister 2 hinterlegt. D. h., beim Start des dynamischen Wägeverfahrens mittels des A/D-Wandlers 1 wird dem Steuerungsmodul 4 zur Initialisierung des Umsetzverfahrens ein Messwert für den vorangegangenen Messwert Ue(m-1) als Vergleichswert V vorgegeben. Das Approximationsregister 2 ist dabei derart ausgebildet, dass zur Bestimmung des digitalen Signals Ze(m) nur innerhalb des Toleranzbereiches T liegende Vergleichswerte V neu bestimmt werden. Beispielhaft werden beim oben beschriebenen dynamischen Wägeverfahren lediglich drei Approximationsstufen N₁ bis N₃ mit entsprechender Anzahl von Wandlungsschritten durchlaufen. Dazu wird der Vergleichswert V in der jeweiligen Approximationsstufe N₁ bis N₃ innerhalb des Toleranzbereiches um den betreffenden Wert addiert und/oder subtrahiert.

Je nach Art und Ausbildung des A/D-Wandlers 1 ist dieser, wie oben bereits beschrieben, derart ausgebildet, dass der Toleranzbereich T anhand der Änderung des analogen Signals Ue von zwei aufeinander folgenden Abtastungen bestimmt und angepasst wird. Mit anderen Worten: Der Toleranzbereich T kann prinzipiell in seiner Größe variieren. Darüber hinaus kann der Toleranzbereich T in seiner Lage verändert, insbesondere an das vorangegangene analoge Signal Ue(m-1) angepasst werden. Hierzu wird der Toleranzbereich T mit der vorgegebenen Größe an seinen Grenzen beliebig verschoben. Beispielsweise beträgt der Toleranzbereich T 10 bis 26 Volt für das vorangegangene analoge Signal Ue(m-1) von 17 Volt und der Messbereich M 0 bis 100 Volt. Bei einer Anpassung der Lage des Toleranzbereiches T an das vorangegangene analoge Signal Ue(m-1) wird bei einem aktuell erfassten analogen Signal Ue(m) von 15 Volt die Grenze G des Toleranzbereiches T von 7 bis 23 Volt verschoben. Mit anderen Worten: Der Toleranzbereich T beträgt +/-8 Volt, wobei das vorangegangene analoge Signal Ue(m-1) die Mitte des Toleranzfensters oder -bereiches T bildet. Somit wird sichergestellt, dass die Anpassung oder Veränderung des Toleranzbereiches T zulässig ist, d. h., dass mindestens ein Vergleichswert V neu bestimmt wird. Durch eine derartig dynamische Anpassung des Wägeverfahrens durch Änderung der Lage und/oder Größe des Toleranzbereiches T zur dynamischen Begrenzung der Approximationsstufen N ist eine deutliche Verkürzung der Wandlungszeiten unter Berücksichtigung, d. h. insbesondere Filterung, von sporadisch auftretenden Störimpulsen im analogen Signal Ue sichergestellt. Liegt beispielsweise zum Zeitpunkt der Abtastung und somit zum Zeitpunkt der Erfassung eines aktuellen analogen Signals Ue(m) ein Störimpuls vor, so kann der Messwert maximal bis zur Grenze des eingestellten Toleranzbereiches T, auch Dynamikfenster genannt, verfälscht werden. Mit anderen Worten: Die Begrenzung des Toleranzbereiches T bewirkt eine Glättung des analogen Signals Ue ohne zusätzliche Filterschaltung.

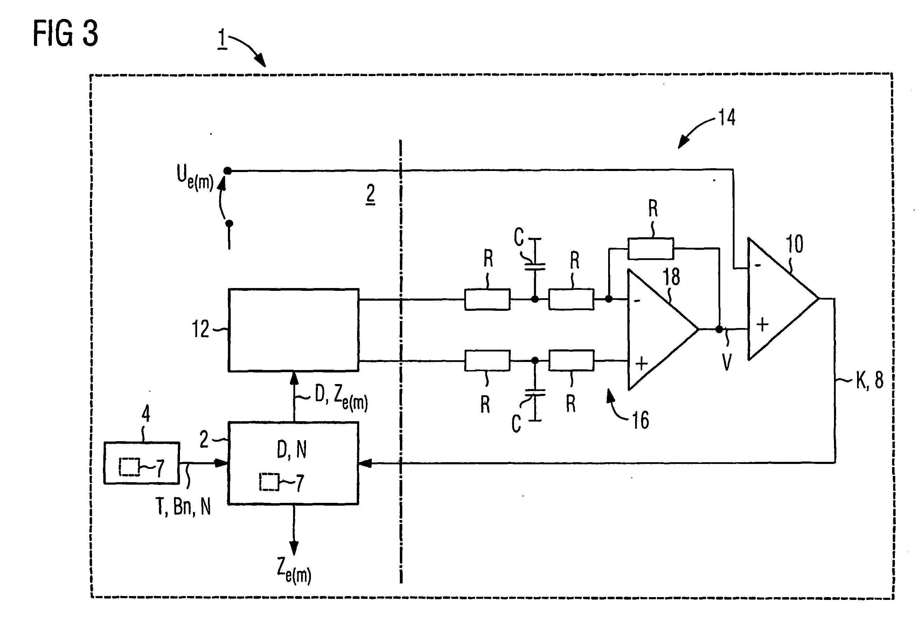

Figur 3 zeigt den A/D-Wandler 1 nach Figur 1 für ein dynamisches Wägeverfahren in Kombination mit einem Pulsdichte-Verfahren zur Bildung des Vergleichswertes V. Zur Zuführung des Vergleichswertes V an den Komparator 10 umfasst der A/D-Wandler 1 einen Digital-Analog-Wandler 12 nach dem so genannten Pulsdichte-Verfahren. Der Aufbau und die Funktionsweise des Digital-Analog-Wandlers 12 nach dem so genannten Pulsdichte-Verfahren entsprechend der Figur 3 ist u. a. in der deutschen Anmeldung DE 195 18 515 A1 beschrieben, die voll inhaltlich in die vorliegende Patentanmeldung mit einbezogen wird ("incorporated by references").

Bevorzugt sind das Steuerungsmodul 4 sowie das Approximationsregister 2 und der zur Zuführung des vorangegangenen Vergleichswertes V vorgesehene D/A-Wandler 12 als integrierte Schaltungen ausgeführt. Zur Erfassung der Abweichung des Vergleichswertes V vom aktuell erfassten analogen Signal Ue(m) ist ein analoger Schaltungsteil 14 in Form einer Operationsverstärkerschaltung 16 mit dem nachgeschalteten Komparator 10 vorgesehen. Zur Bildung des Gleichanteils des als Puls-Pausen-Signal am Komparator 10 anliegenden Vergleichswertes V umfasst die Operationsverstärkerschaltung 16 verschiedene Widerstände R, Kondensatoren C sowie einen Differenzverstärker 18. Die Widerstände R und die Kondensatoren C stellen Tiefpässe zum Einglätten des Puls-Pausen-Signals dar. Die Widerstände R zur Beschaltung des Differenzverstärkers 18 bewirken einen entsprechend hohen Pegel für den am Ausgang anliegenden Vergleichswert V (= Vergleichswert für die Eingangsspannung).

Die Kombination des dynamischen Wägeverfahrens mit dem Pulsdichte-Verfahren des Digital-Analog-Wandlers 12 ermöglicht eine besonders einfache Ausführung in Form von digitalen Schaltkreisen. Darüber hinaus ermöglicht der Digital-Analog-Wandler 12 nach dem Pulsdichte-Verfahren bedingt durch dessen begrenzte Dynamik beim Erfassen des Vergleichswertes eine weitgehend kurze Einschwingzeit, so dass die Verkürzung des dynamischen Wägeverfahrens mit dem A/D-Wandler 1 weitgehend erhalten bleibt.

## Patentansprüche

1. Verfahren zur Wandlang eines analogen Signals (Ue(m)) in ein digitales Signal (Ze) einer Signalfolge mit einer vorgegeben festen Bitauflösung (Bn) für einen vorgegebenen Messbereich (M), bei dem das analoge Signal (Ue(m)) derart stufenweise approximiert wird **dadurch gekennzeichnet, dass** eine den Messbereich (M) repräsentierende Anzahl von Approximationsstufen (N) zur Wandlung eines aktuell erfassten analogen Signals (Ue(m)) anhand eines Toleranzbereiches (T) begrenze wird, wobei der Toleranzbereich (T) anhand eines dem aktuellen analogen Signal (Ue(m)) vorangegangenen analogen Signals (Ue(m-1)) bestimmt wird.

2. Verfahren nach Anspruch 1, bei dem für ein innerhalb des Toleranzbereiches (T) liegendes aktuelles analoges Signal (Ue(m)) das digitale Signal (Ze) bestimmt wird.

3. Verfahren nach Anspruch 1 oder 2, bei dem für ein außerhalb des Toleranzbereiches (T) liegendes aktuelles analoges Signal (Ue(m)) der vorangegangene digitale Wert (Ze) beibehalten oder ein den Toleranzbereich (T) repräsentierender Grenzwert (G) bestimmt und angenommen wird.

4. Verfahren nach einem der Ansprüche 1 bis 3, bei dem die Größe des Toleranzbereiches (T) von einer Approximationsstufe (N₁) bis zur maximalen Anzahl von Approximationsstufen (Nₘₐₓ) vorgegeben wird.

5. Verfahren nach einem der Ansprüche 1 bis 4, bei dem die Größe des Toleranzbereiches (T) anhand der Änderung von vorangegangenen Signalen (Ue(m-1) - Ue(m-2)) von mindestens zwei aufeinander folgenden Abtastungen bestimmt und/oder angepasst wird.

6. Verfahren nach einem der Ansprüche 1 bis 5, bei dem die Lage des Toleranzbereiches (T) anhand des vorangegangenen analogen Signals (Ue(m-1)) derart bestimmt wird, dass dieses die Mitte des Toleranzbereiches (T) bildet.

7. Vorrichtung (1) zur Wandlung eines analogen Signals (Ue(m)) in ein digitales Signal (Ze) einer Signalfolge mit einer vorgegebenen festen Bitauflösung (Bn) für einen vorgegebenen Messbereich (M) mit einem Steuerungsmodul (4) zur Bestimmung und Einstellung eines Toleranzbereiches (T) **dadurch gekennzeichnet dass**, anhand des Toleranzbereiches ein Steuersignal (S) zur Steuerung eines sukzessiven Approximatilonsregisters (2) derart generierbar ist, dass die zur Digitalisierung des analogen -Signals (Ue(m)) zu durchlaufenden Approximationsstufen (N) des Approximationsregisters (2) begrenzbar sind.

8. Vorrichtung nach Anspruch 7, bei dem ein Eingabemodul (6) zur Vorgabe des Toleranzbereiches (T) anhand von Grenzwerten (G) vorgesehen ist.

9. Vorrichtung nach Anspruch 7 oder 8, bei dem ein Differenzmodul (7) zur Bestimmung der Änderung des aktuellen analogen Signals (Ue(m)) vom vorangegangenen analogen Signal (Ue(m-1)) vorgesehen ist.

10. Vorrichtung (1) nach einem der Ansprüche 7 bis 9, bei dem ein Digital-Analog-Wandler (12) zur Ermittlung und Zuführung eines die jeweilige Approximationsstufe (N₁ bis Nₘₐₓ) repräsentierenden Vergleichswertes (V) an einen Komparator (10) vorgesehen ist.

11. Vorrichtung (1) nach Anspruch 10, bei dem der Digital-Analog-Wandler (12) aus dem vorangegangenen digitalen Signal (Ze(m-1), D) den als Puls-Pausen-Signal gebildeten analogen Vergleichswert (V) erzeugt.

12. Vorrichtung (1) nach einem der Ansprüche 7 bis 11, bei dem das Steuerungsmodul (4) zur Anpassung des Toleranzbereiches (T) anhand der Änderung des analogen Signals (Ue(m-1) - Ue(m-n)) von mindestens zwei aufeinander folgenden Abtastungen ausgebildet ist.

13. Vorrichtung (1) nach einem der Ansprüche 7 bis 12, bei dem das Approximationsregister (2) als integrierte Schaltung ausgeführt ist.

14. Vorrichtung (1) nach einem der Ansprüche 7 bis 12, bei dem der Digital-Analog-Wandler (12) als integrierte Schaltung ausgebildet ist.

15. Vorrichtung (1) nach einem der Ansprüche 7 bis 14, bei dem der analoge Schaltungsteil (14) und der digitale Schaltungsteil als eine integrierte Schaltung ausgebildet sind.

## Claims

1. Method for converting an analogue signal (Ue(m)) into a digital signal (Ze) of a signal sequence with a predetermined fixed bit resolution (Bn) for a predetermined measuring range (M), in which the analogue signal (Ue(m)) is approximated step by step, **characterized in that** a number of approximation steps (N), representing the measuring range (M), for converting a currently detected analogue signal (Ue(m)) is limited by means of a tolerance range (T), wherein the tolerance range (T) is determined by means of an analogue signal (Ue(m-1)) preceding the current analogue signal (Ue(m)).

2. Method according to Claim 1, in which the digital signal (Ze) is determined for a current analogue signal (Ue(m)) lying within the tolerance range (T).

3. Method according to Claim 1 or 2, in which, for a current analogue signal (Ue(m)) lying outside the tolerance range (T), the preceding digital value (Ze) is retained or a limit value (G) representing the tolerance range (T) is determined and accepted.

4. Method according to one of Claims 1 to 3, in which the size of the tolerance range (T) is predetermined from one approximation step (N₁) up to the maximum number of approximation steps (Nₘₐₓ).

5. Method according to one of Claims 1 to 4, in which the size of the tolerance range (T) is determined and/or adapted by means of the change of preceding signals (Ue(m-1) - Ue(m-2)) from at least two successive samples.

6. Method according to one of Claims 1 to 5, in which the position of the tolerance range (T) is determined by means of the preceding analogue signal (Ue(m-1)), in such a manner that the latter forms the centre of the tolerance range (T).

7. Device (1) for converting an analogue signal (Ue(m)) into a digital signal (Ze) of a signal sequence with a predetermined fixed bit resolution (Bn) for a predetermined measuring range (M), comprising a control module (4) for determining and setting a tolerance range (T), **characterized in that** a control signal (S) for controlling a successive approximation register (2) can be generated by means of the tolerance range in such a manner that the approximation steps (N) of the approximation register (2) to be passed for digitizing the analogue signal (Ue(m)) can be limited.

8. Device according to Claim 7, in which an input module (6) for inputting the tolerance range (T) by means of limit values (G) is provided.

9. Device according to Claim 7 or 8, in which a differential module (7) is provided for determining the change in the current analogue signal (Ue(m)) from the preceding analogue signal (Ue(m-1)).

10. Device (1) according to one of Claims 7 to 9, in which a digital/analogue converter (12) is provided for determining and supplying a reference value (V), representing the respective approximation step (N₁ to Nₘₐₓ), to a comparator (10).

11. Device (1) according to Claim 10, in which the digital/analogue converter (12) generates from the preceding digital signal (Ze(m-1), D) the analogue reference value (V) formed as rectangular-pulse signal.

12. Device (1) according to one of Claims 7 to 11, in which the control module (4) is constructed for adapting the tolerance range (T) by means of the change in the analogue signal (Ue(m-1) - Ue(m-n)) from at least two successive samples.

13. Device (1) according to one of Claims 7 to 12, in which the approximation register (2) is constructed as integrated circuit.

14. Device (1) according to one of Claims 7 to 12, in which the digital/analogue converter (12) is constructed as integrated circuit.

15. Device (1) according to one of Claims 7 to 14, in which the analogue circuit section (14) and the digital circuit section are constructed as one integrated circuit.

## Revendications

1. Procédé pour la conversion d'un signal analogique (Ue (m)) en un signal numérique (Ze) d'une séquence de signal avec une résolution binaire fixe prédéterminée (Bn) pour une plage de mesure prédéterminée (M), **caractérisé par le fait qu'**on effectue une approximation progressive du signal analogique (Ue (m)) de telle sorte qu'un nombre, représentant la plage de mesure (M), de niveaux d'approximation (N) pour la conversion d'un signal analogique actuellement détecté (Ue (m)) est limité à l'aide d'une plage de tolérance (T), la plage de tolérance (T) étant déterminée à l'aide d'un signal analogique (Ue (m - 1)) antérieur au signal analogique actuel (Ue (m)).

2. Procédé selon la revendication 1, dans lequel, pour un signal analogique actuel (Ue (m)) se trouvant à l'intérieur de la plage de tolérance (T), on détermine le signal numérique (Ze).

3. Procédé selon la revendication 1 ou 2, dans lequel, pour un signal analogique actuel (Ue (m)) se trouvant en dehors de la plage de tolérance (T), on conserve la valeur numérique antérieure (Ze) ou on détermine et suppose une valeur limite (G) représentant la plage de tolérance (T).

4. Procédé selon l'une des revendications 1 à 3, dans lequel on prescrit la grandeur de la plage de tolérance (T) d'un niveau d'approximation (N₁) jusqu'au nombre maximal de niveaux d'approximation (Nₘₐₓ).

5. Procédé selon l'une des revendications 1 à 4, dans lequel on détermine et/ou adapte la grandeur de la plage de tolérance (T) à l'aide de la variation de signaux antérieurs (Ue (m - 1) - Ue (m - 2)) d'au moins deux échantillonnages successifs.

6. Procédé selon l'une des revendications 1 à 5, dans lequel on détermine la position de la plage de tolérance (T) à l'aide du signal analogique antérieur (Ue (m - 1)) de telle sorte que celui-ci forme le centre de la plage de tolérance (T).

7. Dispositif (1) pour la conversion d'un signal analogique (Ue (m)) en un signal numérique (Ze) d'une séquence de signal avec une résolution binaire fixe prédéterminée (Bn) pour une plage de mesure prédéterminée (M) avec un module de commande (4) pour la détermination et le réglage d'une plage de tolérance (T), **caractérisé par le fait qu'**un signal de commande (S) pour la commande d'un registre successif d'approximation (2) peut être produit de telle sorte à l'aide de la plage de tolérance que les niveaux d'approximation (N) du registre d'approximation (2) qui sont à parcourir pour la numérisation du signal analogique (Ue (m)) peuvent être limités.

8. Dispositif selon la revendication 7, dans lequel un module d'entrée (6) est prévu pour prescrire la plage de tolérance (T) à l'aide de valeurs limites (G).

9. Dispositif selon la revendication 7 ou 8, dans lequel un module de différence (7) est prévu pour déterminer la variation du signal analogique actuel (Ue (m)) par rapport au signal analogique antérieur (Ue (m - 1)).

10. Dispositif (1) selon l'une des revendications 7 à 9, dans lequel un convertisseur numérique-analogique (12) est prévu pour déterminer une valeur de comparaison (V) représentant le niveau d'approximation respectif (N₁ à Nₘₐₓ) et pour la transmettre à un comparateur (10).

11. Dispositif (1) selon la revendication 10, dans lequel le convertisseur numérique-analogique (12) produit à partir du signal numérique antérieur (Ze (m - 1), D) la valeur de comparaison analogique (V) formée comme un signal d'impulsions et de pauses.

12. Dispositif (1) selon l'une des revendications 7 à 11, dans lequel le module de commande (4) est conçu pour adapter la plage de tolérance (T) à l'aide de la variation du signal analogique (Ue (m - 1) - Ue (m - n)) d'au moins deux échantillonnages successifs.

13. Dispositif (1) selon l'une des revendications 7 à 12, dans lequel le registre d'approximation (2) est réalisé comme un circuit intégré.

14. Dispositif (1) selon l'une des revendications 7 à 12, dans lequel le convertisseur numérique-analogique (12) est réalisé comme un circuit intégré.

15. Dispositif (1) selon l'une des revendications 7 à 14, dans lequel la partie de circuit analogique (14) et la partie de circuit numérique sont conçues comme un circuit intégré.
